# EUROPEAN PATENT APPLICATION

(11) **EP 2 282 609 A1**
(43) Date of publication of application: **09.02.2011**
(21) Application number: 09729023.3
(22) Date of filing: 24.03.2009
(51) Int. Cl.: H05B 33/10, H01L 51/50

(54) **LYOPHILIC/LYOPHOBIC PATTERN-FORMING METHOD AND ORGANIC ELECTROLUMINESCENT ELEMENT MANUFACTURING METHOD**

(30) Priority: 31.03.2008 JP 2008090688
(71) Applicant: Sumitomo Chemical Company, Limited, Tokyo 104-8260 (JP)
(72) Inventor: ITO, Norihito, Misato-shi Saitama 341-0012 (JP)
(74) Representative: Duckworth, Timothy John
(86) International application number: PCT/JP2009/055779
(87) International publication number: WO 2009/122957

(57) **Abstract**

Disclosed is a lyophilic/lyophobic pattern-forming method comprising a first lyophilization step for lyophilizing the surface of a first member and a second member provided on the first member and having through-holes formed down to the surface of the first member, a lyophobic layer-forming step for forming a lyophobic layer on the surfaces of the first and second members, and a second lyophiliziation step that lyophilizes said lyophobic layer to form a lyophilic/lyophobic pattern, wherein said first and second members are made of different materials, and the lyophobic layer comprises material, wherein locations formed on the first member are lyophilized more than locations formed on the surface of the second member during the second lyophilization step.

## Description

### TECHNICAL FIELD

The present invention relates to a liquid-philic/liquid-repllent pattern forming method and an organic electroluminescent device (hereinafter, also referred to as organic EL device) manufacturing method.

### BACKGROUND ART

Display panels for display devices using an organic EL device are configured with a plurality of organic EL devices arranged in a matrix on a substrate. Such a display panel is produced by first forming each of the organic EL device electrodes on a substrate, then forming a partition arranged in a lattice shape. Next, a liquid for a light-emitting layer, for example, is dropped on each region enclosed by the partition to form the light-emitting layer and the like, and then the electrodes are formed.

If the electrodes formed on the substrate exhibit liquid-repellency, the liquid agglomerates, which can prevent the liquid from being uniformly coated on the electrodes. Further, if the partition exhibits liquid-philicity, the liquid may not all fit within the partition, so that the liquid may dry while some of it is still protruding out of the partition, and a layer having a uniform film thickness cannot be formed within the partition in some cases. Therefore, a treatment for selectively forming a region exhibiting liquid-repellency and a region exhibiting liquid-philicity is carried out on the substrate. This treatment is carried out so that the electrodes exhibit liquid-philicity and the partition exhibits liquid-repellency. In CF₄ plasma treatment, organic materials are more easily fluorinated than inorganic materials. Therefore, by carrying out a CF₄ plasma treatment on the substrate, on which the electrodes are formed from an inorganic material such as indium tin oxide ("ITO") and the partition is formed from an organic resin, the electrodes are made to exhibit liquid-philicity and the partition is made to exhibit liquid-repellency (e.g., refer to PATENT DOCUMENTS 1 and 2).

PATENT DOCUMENT 1: JP 2007-035550 A
PATENT DOCUMENT 2: JP 2002-222695 A

### DISCLOSURE OF THE INVENTION

### PROBLEMS TO BE SOLVED BY THE INVENTION

Methods which are different from those of the conventional art for selectively forming a region exhibiting liquid-philicity and a region exhibiting greater liquid-repellency than the region exhibiting liquid-philicity are being attempted.

Therefore, it is an object of the present invention to provide a liquid-philic/liquid-repellent pattern forming method for selectively forming a region exhibiting liquid-philic and a region exhibiting liquid-repellency, and a method for manufacturing an organic electroluminescent device which uses such method.

### MEANS FOR SOLVING THE PROBLEMS

The present invention is a liquid-philic/liquid-repellent pattern forming method including:
a first liquid-philization step of liquid-philizing surfaces of a first member and a second member which is provided on the first member and in which a through hole leading to the surface of the first member is provided;
a liquid-repellent layer forming step of forming a liquid-repellent layer on the surfaces of the first and second members; and
a second liquid-philization step of liquid-philizing the liquid-repellent layer to form a liquid-philic/liquid-repellent pattern,
wherein in that the first member and the second member are formed of different materials, and
the liquid-repellent layer includes a material which is liquid-philized in the second liquid-philization step in a portion formed on the first member more than in a portion formed on the surface of the second member.
Further, the present invention is the above-described liquid-philic/liquid-repellent pattern forming method, wherein at least a surface portion of the first member is formed of an inorganic material, and at least a surface portion of the second member is formed of an organic material.
Further, the present invention is the above-described liquid-philic/liquid-repellent pattern forming method, wherein the liquid-repellent layer formed in the liquid-repellent layer forming step includes a silane coupling material having a fluoroalkyl group.
Further, the present invention is the above-described liquid-philic/liquid-repellent pattern forming method, wherein in the liquid-repellent layer forming step, the liquid-repellent layer is formed by an applying method using a liquid including a material to constitute the liquid-repellent layer.
Further, the present invention is the above-described liquid-philic/liquid-repellent pattern forming method, wherein in the first and second liquid-philization steps, liquid-philization is carried out by a UV-ray ozone treatment.
Further, the present invention is the above-described liquid-philic/liquid-repellent pattern forming method, wherein a plasma treatment is carried out after the second liquid-philization step. Further, the present invention is the above-described liquid-philic/liquid-repellent pattern forming method, wherein liquid-philization is carried out by an oxygen plasma treatment in at least one of the first and second liquid-philization steps, and
a plasma treatment is carried out after the second liquid-philization step.
Further, the present invention is the above-described liquid-philic/liquid-repellent pattern forming method, wherein the plasma treatment is carried out in an atmosphere including a fluorine-containing gas. Further, the present invention is a method for manufacturing an organic electroluminescent device including at least a first electrode, a second electrode, and a light-emitting layer positioned between the first and second electrodes, the method including:
preparing a substrate provided with a first member which functions as a first electrode and a second member which is provided on the first member and in which a through hole leading to a surface of the first member is provided;
forming a liquid-philic/liquid-repellent pattern by performing the above-described liquid-philic/liquid-repellent pattern forming method;
forming a light-emitting layer by applying a liquid including a material which is to form the light-emitting layer to the inside of the through hole; and
forming a second electrode.

### ADVANTAGES OF THE INVENTION

According to the present invention, a region exhibiting liquid-philic and a region exhibiting liquid-repellency can be selectively formed so that a surface of a first member exhibits liquid-philic and a second member exhibits liquid-repellency.

### BRIEF DESCRIPTION OF THE DRAWINGS

Fig. 1 is a diagram schematically illustrating the respective steps of a liquid-philic/liquid-repellent pattern forming method according to an embodiment of the present invention; and
Fig. 2 is a diagram schematically illustrating the respective steps of a liquid-philic/liquid-repellent pattern forming method according to another embodiment of the present invention.

### BEST MODE FOR CARRYING OUT THE INVENTION

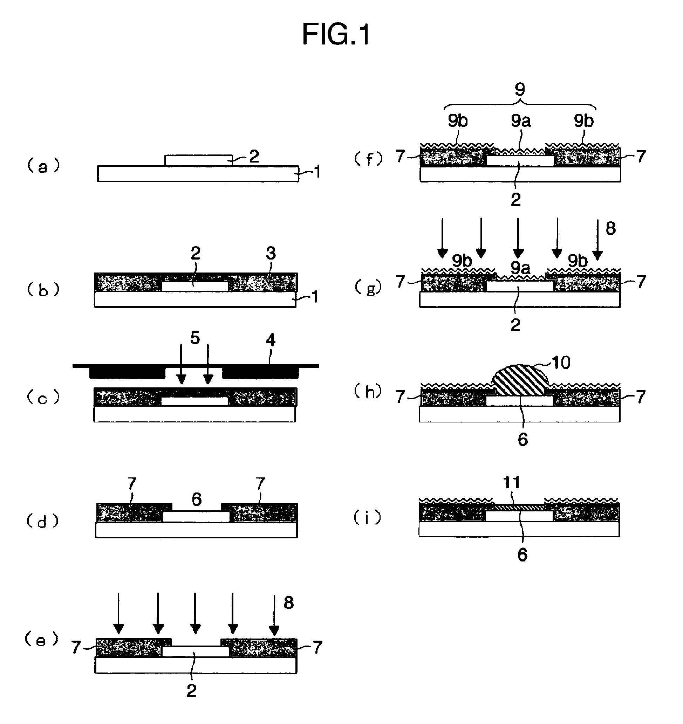

Fig. 1 is a diagram schematically illustrating the respective steps (a) to (i) of a liquid-philic/liquid-repellent pattern forming method according to an embodiment of the present invention. The liquid-philic/liquid-repellent pattern forming method according to the present embodiment includes a first liquid-philization step of liquid-philizing surfaces of a first member and a second member, which is provided on a surface of the first member and in which a through hole leading to the surface of the first member is provided, a liquid-repellent layer forming step of forming a liquid-repellent layer on surfaces of the first and second members, and a second liquid-philization step of liquid-philizing the liquid-repellent layer to form a liquid-philic/liquid-repellent pattern. The first and second members are formed of different materials. The liquid-repellent layer includes a material which is liquid-philized in the second liquid-philization step in a portion formed on the first member more than in a portion formed on the surface of the second member.

First, a substrate on which the first member and the second member are formed is prepared. As illustrated in Fig. 1(a), first, a first member 2 is formed on a substrate 1.
This first member is used as a first electrode of the below-described organic EL device. As the substrate, it is preferred to use a substrate that does not change during the step of manufacturing the below-described organic EL device. Examples include glass, plastic, polymer film, and a silicon substrate, as well as a laminate of these.
The first member is formed of a different material from the second member. In the present embodiment, at least the surface portion is formed of an inorganic material.
The first member is formed of a material to constitute the below-described anode or cathode, for example. More specifically, the first member is formed of a transparent conductive material such as indium tin oxide (ITO), a metal material, a metal oxide material and the like. The first member is formed in a predetermined shape on the surface of the substrate by a method such as sputtering or vapor deposition.

Next, as illustrated in Figs. 1(b) to 1(e), a second member 7 is formed. The second member 7 is provided on the surface of the first member 2, and a through hole leading to the surface of the first member 2 is provided thereon.
Not all of the second member has to be provided on the surface of the first member. As viewed from a thickness direction of the substrate, it is sufficient if at least a peripheral portion of the first member is covered by the second member. At least a surface portion of the second member is formed of an organic material.
The second member is not especially limited, as long as it is formed of an organic material. However, the second member is preferably formed using a photosensitive material such as a photoresist, as this makes manufacturing simple. Examples of such a material include a novolac positive resist, an acrylic negative resist, and a photosensitive polyimide.

First, as illustrated in Fig. 1(b), a liquid 3 including a photosensitive resin is coated on the substrate 1. In the present embodiment a case will be described in which a positive photosensitive resin is used. Next, as illustrated in Fig. 1(c), light 5 is irradiated on a predetermined region via a photomask 4. More specifically, light is irradiated on the region where the above-described through hole is to be formed. Next, as illustrated in Fig. 1(d), a developing treatment is carried out to form a through hole 6 on the region where the light was irradiated, to thereby form the second member 7. This second member 7 functions as a so-called partition.

Next, as illustrated in Fig. 1(e), a first liquid-philization step is carried out for liquid-philizing the surfaces of the first member 2 and the second member 7. Examples of the first liquid-philization step include a UV-ray ozone treatment and an oxygen plasma treatment. In the present embodiment, a UV-ray ozone treatment 8 is carried out on the whole surface of the substrate. By carrying out this first liquid-philization step, the surfaces of the first member 2 and the second member 7 are liquid-philized.

Next, as illustrated in Fig. 1(f), a liquid-repellent layer forming step is carried out for forming a liquid-repellent layer 9 on the surfaces of the first member 2 and the second member 7. In this step, the formed liquid-repellent layer 9 comprises a material which is liquid-philized in the second liquid-philization step in a portion 9a formed on the first member 2 more than in a portion 9b formed on the surface of the second member 7.
It is preferred that the liquid-repellent layer is manufactured using a silane coupling material having a fluoroalkyl group. Examples of the silane coupling material include nonafluorohexyltrichlorosilane, nonafluorohexyldimethylchlorosilane, nonafluorohexytrimethoxysilane, nonafluorohexytriethoxysilane, heptadecafluoro-1,1,2,2-tetrahydroxyltriethoxysilane, heptadecafluoro-1,1,2,2-tetrahydroxyltrimethoxysilane, heptadecafluoro-1,1,2,2-tetrahydrodecyltrichlorosilane, heptadecafluoro-1,1,2,2-tetrahydrodecylmethyldichlorosilane, and heptadecafluoro-1,1,2,2-tetrahydrodecyldimethylchlorosilane.

Examples of methods for forming the liquid-repellent layer include spin coating, printing, slit coating, and bar coating using a solution including the material to form the liquid-repellent layer as a liquid. Of these, from the perspective of ease of formation, it is preferred to use spin coating.

Examples of the solvent for the liquid for forming the liquid-repellent layer include water, methanol, or a mixture thereof. The thickness of the liquid-repellent layer is, for example, 0.1 nm to 100 nm, and preferably 0.1 nm to 20 nm.

Next, as illustrated in Fig. 1(g), a second liquid-philization step is carried out for liquid-philizing the liquid-repellent layer 9. Examples of the second liquid-philization step include a UV-ray ozone treatment and an oxygen plasma treatment. Further, examples of the plasma treatment include a plasma treatment carried out under a vacuum, and a plasma treatment carried out under atmospheric pressure. In the present embodiment, similar to the first liquid-philization step, a UV-ray ozone treatment 8 is carried out on the whole surface of the substrate.

As described above, the liquid-repellent layer 9 comprises a material which is liquid-philized in the second liquid-philization step in a portion 9a formed on the first member 2 more than in a portion 9b formed on the surface of the second member 7. Therefore, by carrying out the second liquid-philization step, within the liquid-repellent layer, the site 9a positioned in contact with the first member 2 exhibits relatively more liquid-philic, and the site 9b positioned in contact with the second member 7 exhibits relatively more liquid-repellency.
The term liquid-philization of a surface (layer) refers to increasing the affinity of the surface (layer) to a liquid. Examples of the liquid include the liquid for forming another layer by an applying method on the surface (layer). The term lyophobization refers to repelling a liquid.
When a surface (layer) is liquid-repellent, generally, the contact angle of the liquid with the surface is 20° or more, and preferably 30° or more. When a surface (layer) is liquid-philic, generally, the contact angle of the liquid with the surface is less than 20°, and preferably 15° or less.

Fig. 1(h) illustrates a state in which, on such a substrate, a liquid 10 is coated in the through hole 6 of the second member 7 in an amount that is larger than the capacity of the region enclosed by the second member 7. Since the bottom face of the hole 6 is liquid-philic, the liquid spreads on the bottom face of the hole 6. Moreover, since the liquid-repellent layer formed on the second member 7 is liquid-repellent, the liquid 10 swells around the hole 6 without spreading on the second member 7. In this state, if the liquid 10 is dried, during the drying process, all of the liquid 10 fits within the hole 6. Consequently, a film 11 having a uniform thickness can be formed (Fig. 1(i)).

According to the above-described liquid-philic/liquid-repellent pattern forming method of the present embodiment, the first and second liquid-repellent treatments are carried out by a UV-ray ozone treatment 8. Therefore, a liquid-philic/liquid-repellent pattern can be formed more easily than when forming a liquid-philic/liquid-repellent pattern using a plasma treatment. Further, as described below, the liquid-repellent layer 9 formed on the first member 2 functions, for example, as a charge injection layer or a charge transport layer of the organic EL device. Thus, by performing the liquid-philic/liquid-repellent pattern forming method, the charge injection layer, the charge transport layer or the like of the organic EL device is secondarily formed. Therefore, this liquid-philic/liquid-repellent pattern forming method can be preferably used as a method for producing a substrate for an organic EL device.

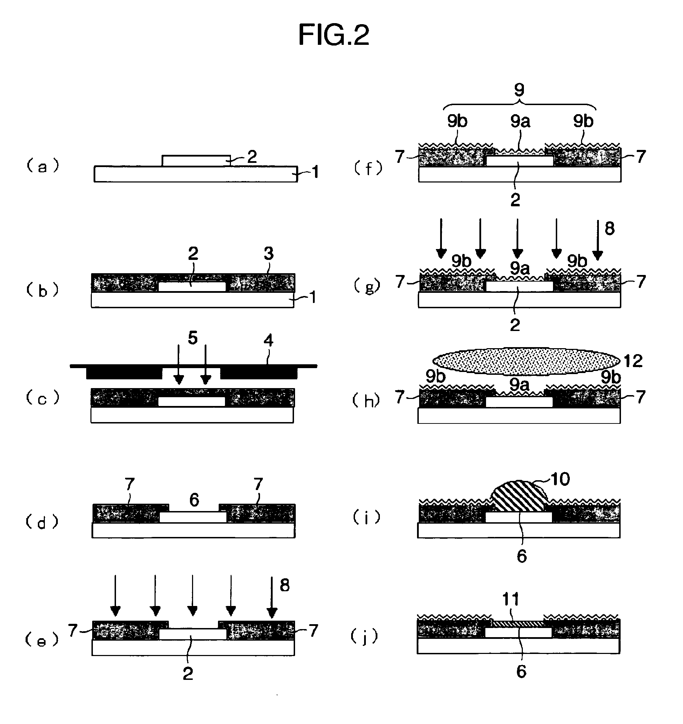

Fig. 2 is a diagram schematically illustrating the respective steps of a liquid-philic/liquid-repellent pattern forming method according to another embodiment of the present invention. The liquid-philic/liquid-repellent pattern forming method according to the present embodiment is a method which adds a treatment for carrying out the above-described plasma treatment to the liquid-philic/liquid-repellent pattern forming method of the above-described embodiment. The treatment for carrying out the plasma treatment is performed after the second liquid-philization step.

The treatments performed in Figs. 2(a) to 2(g) are respectively the same as the treatments performed in Figs. 1(a) to 1(g), and thus overlapping descriptions will be omitted.

In Fig. 2(h), the liquid-repellent layer 9 is subjected to a plasma treatment 12. It is preferred that this plasma treatment is carried out in an atmosphere including a fluorine-containing gas. Examples of the fluorine-containing gas include gases containing a fluorine compound such as SF₆ and CF₄. Among these, as the plasma treatment, a CF₄ plasma treatment using CF₄ for a reactive gas is preferred.

Thus, by subjecting the liquid-repellent layer to the plasma treatment 12, the liquid-repellent layer 9 is made liquid-repellent. In the liquid-repellent layer 9, the level of liquid-repellency of the site 9a formed on the first member 2 and the level of liquid-repellency of the site 9b formed on the second member 7 are different. The liquid-repellent layer 9 is formed of a material which is made more liquid-repellent by the plasma treatment 12 performed on the site 9b formed on the second member 7. By adding this plasma treatment, the difference between the contact angle of the site 9a formed on the surface of the first member 2 and the contact angle of the site 9b formed on the second member 7 is increased. If the liquid 10 is coated in the through hole 6 using a substrate which was subjected to plasma treatment (Figs. 2(i) and 2(j)), a film 11 having a more uniform thickness can be formed.

In at least one of the first and the second liquid-philization steps, when performing liquid-philization by an oxygen plasma treatment, as in the present embodiment, it is preferred to subject the liquid-repellent layer to the plasma treatment after the second liquid-philization step.

In each of the above-described embodiments, the first member was provided on the substrate, and the first member was configured as a different member from the substrate. However, the substrate may be used as a first member, the second member on which the through hole is formed may be provided on the first member corresponding to the substrate, and the liquid-philic/liquid-repellent pattern forming method according to the present invention may be applied to such a substrate.

Next, a method for manufacturing an organic EL device using a liquid-philic/liquid-repellent pattern based on the liquid-philic/liquid-repellent pattern forming method described in Figs. 1 and 2 will be described.

In the method for manufacturing an organic EL device according to the present embodiment, a substrate provided with a first member which functions as a first electrode and a second member which is provided on the first member and in which a through hole leading to the surface of the first member is provided, is prepared, a liquid-philic/liquid-repellent pattern is formed by performing the above-described liquid-philic/liquid-repellent pattern forming method, a light-emitting layer is formed by applying a liquid including a material which is to form the light-emitting layer to the inside of the through hole, and a second electrode is formed.

The organic EL device includes at least a light-emitting layer, and an anode and a cathode which sandwich the light-emitting layer. One of the first and the second electrodes corresponds to the anode, and the other of the first and the second electrodes corresponds to the cathode. Further, the organic EL device according to the present embodiment further includes a liquid-repellent layer formed by a liquid-philic/liquid-repellent pattern forming method. This liquid-repellent layer corresponds to a below-described charge injection layer or charge transport layer. Moreover, the layers provided between the cathode and the anode are not limited to the light-emitting layer and the liquid-repellent layer.

Examples of layers that can be provided between the cathode and the light-emitting layer include an electron injection layer, an electron transport layer, and a hole blocking layer. When both an electron injection layer and an electron transport layer are provided between the cathode and the light-emitting layer, the layer closer to the cathode is called an electron injection layer, and the layer closer to the light-emitting layer is called an electron transport layer.

The electron injection layer is a layer that has a function for improving the electron injection efficiency from the cathode. The electron transport layer is a layer that has a function for improving electron injection from the cathode or the electron injection layer, or from an electron transport layer which is closer to the cathode. A hole blocking layer is a layer that has a function for blocking hole transportation. If the electron injection layer and/or the electron transport layer have a function for blocking hole transportation, these layers can simultaneously serve as a hole blocking layer.

The fact that the hole blocking layer has a function for blocking hole transportation can be confirmed by, for example, producing a device through which only a hole current flows, and confirming whether there is a blocking effect due to a decrease in the current value.

Examples of layers that can be provided between the anode and the light-emitting layer include a hole injection layer, a hole transport layer, and an electron blocking layer. When both a hole injection layer and a hole transport layer are provided, the layer closer to the anode is called a hole injection layer, and the layer closer to the light-emitting layer is called a hole transport layer.

The hole injection layer is a layer that has a function for improving the hole injection efficiency from the anode. The hole transport layer is a layer that has a function for improving hole injection from the anode or the hole injection layer, or from a hole transport layer which is closer to the anode. An electron blocking layer is a layer that has a function for blocking electron transportation. If the hole injection layer and/or the hole transport layer have a function for blocking electron transportation, these layers can simultaneously serve as an electron blocking layer.

The fact that the electron blocking layer has a function for blocking electron transportation can be confirmed by, for example, producing a device through which only an electron current flows, and confirming whether there is a blocking effect due to a decrease in the current value.

The electron injection layer and the hole injection layer may be collectively referred to as charge injection layers, and the electron transport layer and the hole transport layer may be collectively referred to as charge transport layers.

Examples of the layer structures which the organic EL device according to the present embodiment can have are illustrated below.
a) Anode/hole transport layer/light-emitting layer/cathode
b) Anode/light-emitting layer/electron transport layer/cathode
c) Anode/hole transport layer/light-emitting layer/electron transport layer/cathode
d) Anode/charge injection layer/light-emitting layer/cathode
e) Anode/light-emitting layer/charge injection layer/cathode
f) Anode/charge injection layer/light-emitting layer/charge injection layer/cathode
g) Anode/charge injection layer/hole transport layer/light-emitting layer/cathode
h) Anode/hole transport layer/light-emitting layer/charge injection layer/cathode
i) Anode/charge injection layer/hole transport layer/light-emitting layer/charge injection layer/cathode
j) Anode/charge injection layer/light-emitting layer/charge transport layer/cathode
k) Anode/light-emitting layer/electron transport layer/charge injection layer/cathode
l) Anode/charge injection layer/light-emitting layer/electron transport layer/charge injection layer/cathode
m) Anode/charge injection layer/hole transport layer/light-emitting layer/charge transport layer/cathode
n) Anode/hole transport layer/light-emitting layer/electron transport layer/charge injection layer/cathode
o) Anode/charge injection layer/hole transport layer/light-emitting layer/electron transport layer/charge injection layer/cathode
   (here, the symbol "/" represents the fact that respective layers on either side of the "/" are laminated adjacent to each other. Hereinafter the same.)
   The organic EL device according to the present embodiment may also have two or more light-emitting layers. Examples of an organic EL device having two light-emitting layers include the layer structure illustrated in the following p).
p) Anode/charge injection layer/hole transport layer/light-emitting layer/electron transport layer/charge injection layer/charge generation layer/charge injection layer/hole transport layer/light-emitting layer/electron transport layer/charge injection layer/cathode
   Specific examples of an organic EL device having three or more light-emitting layers include, wherein (charge generation layer/charge injection layer/hole transport layer/light-emitting layer/electron transport layer/charge injection layer) is one repeating unit, the layer structure illustrated in the following q) which includes two or more of the above repeating unit.
q) Anode/charge injection layer/hole transport layer/light-emitting layer/electron transport layer/charge injection layer/(the repeating unit)/(the repeating unit)/.../cathode
   In the above-described layer structures p) and q), the respective layers other than the anode, the electrodes, the cathode, and the light-emitting layer can optionally be removed.

Here, the charge generation layer is a layer which generates holes and electrons from the application of an electric field.
Examples of the charge generation layer include thin films formed from vanadium oxide, indium tin oxide (ITO), molybdenum oxide and the like.

To extract the light from the light-emitting layer out of the organic EL device, usually, all of the layers of the organic EL device according to the present embodiment arranged on the side from which the light is extracted, with respect to on the light-emitting layer, are transparent. Here, an example of an organic EL device will be described which has a layer structure of substrate/anode/charge injection layer/hole transport layer/light-emitting layer/electron transport layer/charge injection layer/cathode/sealing member. In the case of a so-called bottom emission type organic EL device, in which the light from the light-emitting layer is extracted from the substrate side, the substrate, the anode, the charge injection layer, and the hole transport layer are all transparent. In the case of a so-called top emission type organic EL device, in which the light from the light-emitting layer is extracted from the sealing member side, the electron transport layer, the charge injection layer, the cathode, and the sealing member are all transparent. As another example, an organic EL device will be described which has a layer structure of substrate/cathode/charge injection layer/electron transport layer/light-emitting layer/hole transport layer/charge injection layer/anode/sealing member. In the case of a bottom emission type device, the substrate, the cathode, the charge injection layer, and the electron transport layer are all transparent. In the case of a top emission type organic EL device, the hole transport layer, the charge injection layer, the cathode, and the sealing member are all transparent. Here, as the level of transparency, it is preferred that the visible light transmittance from the topmost surface from which the light is extracted out of the organic EL device to the light-emitting layer is 40% or more. For an organic EL device in which UV region or infrared region light emission is required, it is preferred that the light transmittance at that region is 40% or more.

To improve adhesion with the electrodes and to improve charge injection from the electrodes, the organic EL device according to the present embodiment may be provided with an insulating layer having a thickness of 2 nm or less adjacent to the electrodes. Further, to improve adhesion at the interfaces and to prevent mixing, and the like, a thin buffer layer may be inserted on at least any one of the interfaces between the above-described respective layers.

The order of the laminated layers, the number of layers, and the thickness of each layer can be appropriately set based on the light emission efficiency and the device life.

Here, an example will be described for a method of manufacturing an organic EL device having a device structure of anode/charge injection layer/light-emitting layer/cathode.

First, a substrate is prepared on which a first member which functions as a first electrode and a second member which is provided on the first member and in which a through hole leading to the surface of the first member is provided, are formed. This step is the same as the treatments illustrated in the above-described Figs. 1(a) to 1(d) or Figs. 2(a) to 2(d), and thus a description thereof will be omitted here. This first member corresponds to the anode in the present embodiment.

Next, using the above-described liquid-philic/liquid-repellent pattern forming method, a substrate is produced on which a liquid-philic region and a region which is more liquid-repellent than the liquid-philic region are selectively formed. As described above, although the liquid-repellent layer is formed by a liquid-philic/liquid-repellent pattern forming method, the liquid-repellent layer functions as a charge injection layer (hole injection layer). Next, a liquid including the material which is to form the light-emitting layer is dropped onto the liquid-repellent layer by, for example, as inkjet apparatus to form the light-emitting layer (corresponding to Figs. 1(h) and 1(i) or Figs. 2(i) and 2(j)). Then, a cathode is formed on the light-emitting layer to obtain an organic EL device.

When forming the hole injection layer by an applying method, in the conventional art, the hole injection layer is formed by dropping the liquid including the material which is to form the hole injection layer into the through hole of the second member corresponding to a partition. However, in the present embodiment, the hole injection layer can be formed by the simple method of spin coating. For example, when forming a plurality of pixels, it was necessary to drop the liquid including the material which is to form the hole injection layer onto each pixel using an inkjet apparatus. However, by using spin coating, the hole injection layer can be formed for all of the pixels in one go, so that the hole injection layer can be easily formed. In addition, for a display panel formed from a plurality of pixels, it was necessary to provide a step of forming a liquid-philic/liquid-repellent pattern. However, in the present invention, a hole injection layer is inevitably formed by undergoing the step of forming this liquid-philic/liquid-repellent pattern. Therefore, the need to provide a step of forming the hole injection layer separate from the step of forming the liquid-philic/liquid-repellent pattern is obviated. Consequently, the manufacturing steps can be simplified.

Next, the materials of layers constituting the organic EL device and the forming method will be described in more detail.

### <Anode>

For an organic EL device configured to extract light from the light-emitting layer via the anode, a transparent or semi-transparent electrode can be used for the anode. A thin film formed from a metal oxide, metal sulfide, metal and the like having a high electrical conductivity is used as the transparent electrode or the semi-transparent electrode. It is preferred to use a thin film having a high light transmittance. More specifically, a thin film formed from indium oxide, zinc oxide, tin oxide, ITO, indium zinc oxide (IZO), gold, platinum, silver, copper and the like is used. Of these, it is preferred to use a thin film formed from ITO, IZO, or tin oxide. Examples of methods for producing the anode include vacuum vapor deposition, sputtering, ion plating, and plating.

A material which reflects light may be used for the anode. Preferred examples of the material include a metal, metal oxide, and metal sulfide having a work function of 3.0 eV or more.

The thickness of the anode can be appropriately selected in consideration of light transmittance and electrical conductivity. The thickness is, for example, 10 nm to 10 µm, preferably 20 nm to 1 µm, and more preferably 50 nm to 500 nm.

### <Hole injection layer and transport layer>

As the hole injection layer, the above-described liquid-repellent layer may be used. Further, as described above, the hole injection layer may be formed by the liquid-philic/liquid-repellent pattern forming method.

A separate hole injection layer and/or a hole transport layer may be additionally formed between the above-described liquid-repellent layer and the light-emitting layer. The material for constituting such a hole injection layer or a hole transport layer is not especially limited, as long as the material can form the layer by an applying method from a solution. Examples of the material include polyvinylcarbazole or derivatives thereof, polysilane or derivatives thereof, polysiloxane derivatives having an aromatic amine in a side chain or in the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, poly(2,5-thienylenevinylene) or derivatives thereof, a phenylamine compound, a starburst-type amine compound, a phthalocyanine compound, amorphous carbon, and polyaniline.
Among these, as the hole transport material, a polymeric hole transport material is preferred, such as polyvinylcarbazole or derivatives thereof, polysilane or derivatives thereof, polysiloxane derivatives having an aromatic amine compound group in a side chain or in the main chain, polyaniline or derivatives thereof, polythiophene or derivatives thereof, polyarylamine or derivatives thereof, poly(p-phenylenevinylene) or derivatives thereof or poly(2,5-thienylenevinylene) or derivatives thereof, Further, more preferred is a polyvinylcarbazole or derivatives thereof, polysilane or derivatives thereof, and polysiloxane derivatives having an aromatic amine in a side chain or in the main chain. When using a low molecular weight hole transport material, it is preferred to use such a material by dispersing it in a polymeric binder.
Further, a separate hole injection layer from the liquid-repellent layer may be formed between the above-described liquid-repellent layer and the substrate. In such a case, the method for forming this hole injection layer is not especially limited. The hole injection layer can be formed by a method such as vacuum vapor deposition, sputtering, and ion plating of, in addition to a material formed by the above-described applying method, an inorganic material such as vanadium oxide, molybdenum oxide, ruthenium oxide, and aluminum oxide.

The solvent used in the film formation from a solution is not especially limited, as long as the solvent can dissolve the hole injection material or the hole transport material. Examples of the solvent include chlorinated solvents such as chloroform, methylene chloride, and dichloroethane, ether solvents such as tetrahydrofuran, aromatic hydrocarbon solvents such as toluene and xylene, ketone solvents such as acetone and methyl ethyl ketone, ester solvents such as ethyl acetate, butyl acetate, and ethyl cellosolve acetate, and water.

Examples of film-forming methods from a solution include applying (coating) methods such as micro gravure coating, gravure coating, spray coating, screen printing, flexographic printing, offset printing, inkjet printing, and nozzle coating.

The optimum thickness of the hole injection layer and the hole transport layer depends on the used material, and is appropriately set so that the drive voltage and the light emission efficiency are appropriate values. Further, the hole injection layer and the hole transport layer need to be thick enough so that pin holes do not form. However, these layers are preferably not too thick, otherwise the drive voltage of the device increases. Therefore, the hole injection layer has a thickness of, for example, from 1 nm to 1 µm, preferably 2 nm to 500 nm, and more preferably 5 nm to 200 nm.

### <Light-emitting layer>

The light-emitting layer is, usually, mainly formed from an organic material which emits fluorescence and/or phosphorescence, or from such organic material and a dopant which assists the organic material. The dopant is added for the purpose of, for example, improving the light emission efficiency, and changing the emission wavelength. The organic material may be a low-molecular weight compound or a high molecular weight compound. Examples of the light-emitting material to constitute the light-emitting layer include the below-described pigment materials, metal complex materials, and polymeric materials, as well as dopant materials added to these.

### (Pigment material)

Examples of the pigment material include a cyclopentamine derivative, a tetraphenyl butadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, an oxadiazole dimer, a pyrazoline dimer, a quinacridone derivative, and a coumarin derivative.

### (Metal complex material)

Examples of the metal complex material include a metal complex having, for a central metal, Al, Zn, Be and the like, or a rare earth metal such as Tb, Eu, and Dy, and for a ligand, an oxadiazole, a thiadiazole, a phenylpyridine, a phenylbenzimidazole, a quinoline structure and the like. Further examples include metal complexes which emit light from a triplet excited state, such as indium complexes and platinum complexes, an aluminum quinolinol complex, a benzoquinolinol beryllium complex, a benzoxazolyl zinc complex, a benzothiazole zinc complex, an azomethyl zinc complex, a porphyrin zinc complex, and europium complexes.

### (Polymeric material)

Examples of the polymeric material include poly(p-phenylenevinylene) derivatives, polythiophene derivatives, poly(p-phenylene) derivatives, polysilane derivatives, polyacetylene derivatives, polyfluorene derivatives, polyvinylcarbazole derivatives, and polymers prepared by polymerizing the above-described pigment material or metal complex light-emitting material.

Of these light-emitting materials, examples of blue emitting materials include distyrylarylene derivatives, oxadiazole derivatives and polymers thereof, polyvinylcarbazole derivatives, poly(p-phenylene) derivatives, and polyfluorene derivatives. Of these, polyvinylcarbazole derivatives, poly(p-phenylene) derivatives, polyfluorene derivatives, and the like, which are polymer materials, are preferred.

Examples of green emitting materials include quinacridone derivatives, coumarin derivatives, and polymers thereof, poly(p-phenylenevinylene) derivatives and polyfluorene derivatives. Of these, poly(p-phenylenevinylene) derivatives, polyfluorene derivatives, and the like, which are polymer materials, are preferred.

Examples of red emitting materials include coumarin derivatives, thiophene ring compounds, and polymers thereof, poly(p-phenylenevinylene) derivatives, polythiophene derivatives, and polyfluorene derivatives. Of these, poly(p-phenylenevinylene) derivatives, polythiophene derivatives, polyfluorene derivatives, and the like, which are polymer materials, are preferred.

### (Dopant material)

Examples of the dopant material include perylene derivatives, coumarin derivatives, rubrene derivatives, quinacridone derivatives, squalium derivatives, porphyrin derivatives, styryl dyes, tetracene derivatives, pyrazolone derivatives, decacyclene, and phenoxazone. The thickness of this light-emitting layer is usually about 2 nm to 200 nm.

### <Method for forming the light-emitting layer>

Examples of methods which can be used for forming the light-emitting layer include coating a solution including the light-emitting material, vacuum vapor deposition, a transfer method and the like. Examples of the solvent used in forming the film from a solution include the same solvents as those for used when forming the hole transport layer from the above-described solution.

Examples of a method for applying a solution including the light-emitting material include applying (coating) methods such as gravure coating, spray coating, and nozzle coating, as well as other applying (coating) methods such as gravure printing, screen printing, flexographic printing, offset printing, reverse printing, and inkjet printing. From the standpoint that pattern formation and separation into multiple colors are easy, printing methods such as gravure printing, screen printing, flexographic printing, offset printing, reverse printing, inkjet printing, and nozzle coating are preferred. Further, for a sublimable low molecular weight compound, vacuum vapor deposition can be used. Moreover, a method in which the light-emitting layer is formed only on a desired region can also be used, by using transfer or thermal transfer performed with a laser.

### <Electron transport layer>

For a device structure in which the cathode is provided on the substrate, the liquid-repellent layer is formed on the top layer of the cathode.
In this case, the above-described liquid-repellent layer can be used as an electron transport layer, and the electron transport layer can be formed by a liquid-philic/liquid-repellent pattern forming method.

If the above-described liquid-repellent layer is not used as the electron transport layer, such as a structure in which the anode is provided on the substrate, a known material can be used for the electron transport material to constitute the electron transport layer. Examples thereof include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof and polyfluorene or derivatives thereof.

Among these, as the electron transport material, preferable are oxadiazole derivatives, benzoquinone or derivatives thereof, anthraquinone or derivatives thereof, or metal complexes of 8-hydroxyquinoline or derivatives thereof, polyquinoline or derivatives thereof, polyquinoxaline or derivatives thereof and polyfluorene or derivatives thereof, and more preferable are 2-(4-biphenylyl)-5-(4-t-butylphenyl)-1,3,4-oxadiazole, benzoquinone, anthraquinone, tris(8-quinolinol)aluminum and polyquinoline.

Examples of methods for forming the electron transport layer include forming from a solution or a molten state. For polymeric electron transport materials, examples include a method in which the layer is formed from a solution or a molten state. When performing film-formation from a solution or a molten state, the polymeric binder may be used simultaneously. Examples of methods for forming the electron transport layer from a solution include the same methods as described above for forming the hole transport layer from a solution.
Further, for a structure in which the cathode is provided on the substrate, an electron transport layer may be additionally formed between the liquid-repellent layer and the light-emitting layer by the above-described methods.

The optimum thickness of the electron transport layer depends on the used material, and is appropriately set so that the drive voltage and the light emission efficiency are appropriate values. Further, the electron transport layer needs to be thick enough so that pin holes do not form. However, the electron transport layer is preferably not too thick, otherwise the drive voltage of the device increases. Therefore, the electron transport layer has a thickness of, for example, from 1 nm to 1 µm, preferably 2 nm to 500 nm, and more preferably 5 nm to 200 nm.

### <Electron injection layer>

For a device structure in which the cathode is provided on the substrate, the liquid-repellent layer is formed on the top layer of the cathode. In this case, the above-described liquid-repellent layer can be used as an electron injection layer. The liquid-repellent layer functioning as the electron injection layer can be formed by a liquid-philic/liquid-repellent pattern forming method, as described above.

If the above-described liquid-repellent layer is not used as the electron injection layer, such as a device structure in which the anode is provided on the substrate, the optimum material for constituting the electron injection layer can be appropriately selected based on the type of light-emitting layer. Examples thereof include alkali metals, alkali earth metals, alloys including one kind or more of alkali metals and alkali earth metals, and an oxide, a halide, a carbonate or a mixture thereof of an alkali metal or an alkali earth metal. Examples of alkali metals and oxides, halides, and carbonates thereof include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate and the like. Examples of alkali earth metals and oxides, halides, and carbonates thereof include magnesium, calcium, barium, strontium, magnesium oxide, magnesium fluoride, calcium oxide, calcium fluoride, barium oxide, barium fluoride, strontium oxide, strontium fluoride, magnesium carbonate and the like. The electron injection layer may be formed from a laminate in which two or more layers are laminated, for example, from LiF/Ca. The electron injection layer may be formed by vapor deposition, sputtering, printing and the like. It is preferred that the electron injection layer has a thickness of about 1 nm to 1 µm.

### <Cathode>

It is preferred that the cathode material has a small work function, allows easy electron injection into the light-emitting layer, and has a high electrical conductivity. Further, for an organic EL device in which light is extracted from the anode side, a material having a high visible light reflectance is preferred as the cathode material so that the light from the light-emitting layer is reflected to the anode side by the cathode. Examples of materials which can be used for the cathode include alkali metals, alkali earth metals, transition metals, and Group III-B metals. Examples of the material used for the cathode include, for example, metals such lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, or an alloy of two kinds or more of these metals, or an alloy of one kind or more of these metals and one kind or more of gold, silver, platinum, copper, manganese, titanium, cobalt, nickel, tungsten, and tin, or graphite or a graphite intercalation compound. Examples of alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy. Further, a transparent conductive electrode formed from a conductive metal oxide, a conductive organic material and the like can also be used as the cathode. Specific examples of the conductive metal oxide include indium oxide, zinc oxide, tin oxide, ITO, and IZO. Specific examples of the conductive organic material include polyaniline or derivatives thereof and polythiophene or derivatives thereof. The cathode may be formed from a laminate in which two or more layers are laminated. Further, the electron injection layer may also be used as the cathode.

The thickness of the cathode can be appropriately selected in consideration of electrical conductivity and durability. The thickness is, for example, 10 nm to 10 µm, preferably 20 nm to 1 µm, and more preferably 50 nm to 500 nm.

Methods for producing the cathode include vacuum vapor deposition, sputtering, or laminating by thermal compression of a metal thin film.

### <Insulating layer>

Examples of the material for the insulating layer include metal fluorides, metal oxides, and organic insulating materials. Examples of organic EL devices provided with an insulating layer having a thickness of 2 nm or less include an organic EL device provided with an insulating layer having a thickness of 2 nm or less which is adjacent to the cathode, and an organic EL device provided with an insulating layer having a thickness of 2 nm or less which is adjacent to the anode.

The organic EL device according to the present embodiment can be used as a planar light source, a light source for a segment display device and a dot matrix display device, and as a backlight for a liquid crystal display device.

When the organic EL device according to the present embodiment is used as a planar light source, a planar anode and cathode can be arranged so as to be superimposed when viewed from the laminating direction. Methods for configuring an organic EL device which emits light in a pattern shape as a light source for a segment display device include arranging a mask formed with a window through which light passes formed in a pattern shape on the surface of the planar light source, forming the organic layer of portions which should be quenched very thickly so that light essentially is not emitted, and forming at least either one electrode of the anode and the cathode in a pattern shape. By forming an organic EL device which emits light in a pattern shape by these methods, and by providing wires so that a voltage can be selectively applied to several electrodes, a segment type display device can be realized that is capable of displaying numbers, characters, simple symbols and the like. To use the organic EL device according to the present embodiment as a light source for a dot matrix display device, the anode and the cathode may be formed in a striped manner, and arranged so that they are orthogonal to each other when viewed from one of the laminated directions. To realize a dot matrix display device capable of partial color display and multi-color display, methods which can be used include selective coating of a plurality of light-emitting materials which emit different colors, and using a color filter and a fluorescence conversion filter. Dot matrix display devices may be passively driven or actively driven by combining with a TFT and the like. These display devices can be used in display devices such as a computer, a television, a personal digital assistant, a cellphone, a car navigation system, and a video camera viewfinder.

Further, the above-described planar light source is a self light-emitting type, which can be preferably used as a backlight for a liquid crystal display device or as a planar light source for lighting. In addition, if a flexible substrate is used, the above-described planar light source can also be used as a curved light source or display device.

### EXAMPLES

### (Example 1)

An organic EL device having a layer structure of an ITO thin film (positive electrode)/liquid-repellent layer (hole injection layer)/intermediate layer/light-emitting layer/cathode (Ba layer/Al layer) was produced on a substrate.

A substrate formed by patterning an ITO thin film (first electrode) on a transparent glass substrate was prepared. Next, photosensitive polyimide (PI) was coated over the whole surface by a spin coating method, and then dried to form a photoresist having a thickness of 1 µm. Next, UV-rays were irradiated on predetermined regions by an alignment exposure apparatus using the a photomask, and the exposed regions were removed using a resist developing solution (manufactured by Nagase & Co., Ltd., NPD-18) Consequently, a rectangular opening having a width of 100 µm and a length of 300 µm was formed in the photoresist layer. In addition, a second member was formed by covering a peripheral portion of the ITO thin film.

Next, a heat treatment was carried out at 230°C for 1 hour in a clean oven to completely thermally cure the polyimide to form an organic insulating layer (second member). Then, a substrate for patterning evaluation was produced having the thus-formed second member, which had a rectangular opening with a width of 100 µm and a length of 300 µm, and the first member, which had a surface of an ITO thin film which was exposed from the opening, provided thereon.

Next, 1 wt.% of nonafluorohexytrimethoxysilane was mixed in a solvent formed by mixing methanol and water in a 5:95 ratio by weight. The resultant mixture was stirred for 15 hours at room temperature to produce a solution for the liquid-repellent layer. Then, the above substrate for patterning evaluation was subjected to a UV-ray ozone treatment for 20 minutes on the substrate surface using a UV-ray ozone cleaning apparatus (UV 312, manufactured by Technovision, Inc.) to carry out a liquid-philization treatment on the whole surface of the substrate for patterning evaluation (first liquid-philization step).

Next, the solution for the liquid-repellent layer was coated by spin coating on the substrate for patterning evaluation, then heat treated at 110°C for 30 minutes on a hot plate to form a liquid-repellent layer.

Next, the substrate for patterning evaluation, which had the liquid-repellent layer formed thereon, was subjected to a UV-ray ozone treatment for 20 minutes on the surface on which the liquid-repellent layer was formed using a UV-ray ozone cleaning apparatus (UV 312, manufactured by Technovision, Inc.) to carry out a liquid-philization treatment on the whole surface of the substrate (second liquid-philization step).

Next, a polymer compound 1 was produced by the method described below. Subsequently, 0.5 wt.% of the polymer compound 1 was dissolved in a solvent formed by mixing anisole and tetralin in a 1:1 ratio by weight to produce a solution for an intermediate layer. Using an inkjet apparatus, the solution for an intermediate layer was coated into the opening formed on the second member. Then, the solution for an intermediate layer was dried on a hot plate for 10 minutes and further, heat treated for 20 minutes on the hot plate at 200°C in nitrogen to form an intermediate layer having a thickness of 20 nm.

### (Preparation example of polymer compound 1)

First, a separable flask including a stirring blade, a baffle, a nitrogen introducing tube whose length was adjustable, a cooling tube, and a thermometer, was charged with 158.29 parts by weight of 2,7-bis(1,3,2-dioxaborolane-2-yl)-9,9-dioctylfluorene, 136.11 parts by weight of bis(4-bromophenyl)-4-(1-methylpropyl)-benzenamine, 27 parts by weight of tricaprylmethylammonium chloride (Aliquat 336, manufactured by Henkel) and 1,800 parts by weight of toluene. While introducing nitrogen from the nitrogen introducing tube, the temperature was increased to 90°C under stirring. After adding 0.066 parts by weight of palladium (II) acetate and 0.45 parts by weight of tri(o-toluyl)phosphine, 573 parts by weight of an aqueous solution of 17.5% sodium carbonate was dropped over one hour. After completion of the dropping, the nitrogen introducing tube was pulled up from the solution surface, and the solution was kept warm under reflux for 7 hours. Then, 3.6 parts by weight of phenylboric acid was added. The temperature was kept warm under reflux for 14 hours, and then cooled to room temperature. The aqueous layer was removed from the reaction solution. Subsequently, the oil layer of the reaction solution was diluted with toluene, and washed with an aqueous solution of 3% acetic acid and deionized water. The separated oil layer was charged with 13 parts by weight of sodium N,N-diethyldithiocarbamate trihydrate, and the resultant mixture was stirred for 4 hours. Then, the mixture was passed through a mixed column of active alumina and silica gel. Toluene was passed through the column to wash the column. The filtrate and the washing solution were mixed, and dropped into methanol to precipitate a polymer. The resultant polymer precipitate was filtered off, and then the precipitate was washed with methanol. Subsequently, the polymer was dried by a vacuum dryer, thus obtaining 192 parts by weight of the polymer. The obtained polymer will be referred to as polymer compound 1. The polystyrene equivalent weight average molecular weight of the polymer compound 1 was 3.7 × 10⁵ and the number average molecular weight was 8.9 × 10⁴.

### (GPC analysis method)

The polystyrene equivalent weight average molecular weight and the number average molecular weight were determined by gel permeation chromatography (GPC). Standard polystyrene manufactured by Polymer Laboratories was used to prepare a GPC calibration curve. The polymer to be measured was dissolved in tetrahydrofuran to a concentration of about 0.02 wt.%, and 10 µL thereof was injected into a GPC apparatus. LC-10ADvp manufactured by Shimadzu Corporation was used as the GPC apparatus. Two PLgel 10 µm MIXED-B columns (300 × 7.5 mm) manufactured by Polymer Laboratories connected in series were used as the column. Tetrahydrofuran was flowed at a flow rate of 1.0 mL/min at 25°C as a mobile phase. A UV detector was used as a detector. Absorbance at 228 nm was measured.

Next, a light-emitting layer was formed on the intermediate layer. First, 1 wt.% of a polymeric light-emitting material (BP361, Sumation Co., Ltd.) was dissolved in a solvent formed by mixing anisole and tetralin in a 1:1 ratio by weight to produce a solution for a light-emitting layer. The solution for a light-emitting layer was coated into the opening formed on the second member. Then, the coated solution for a light-emitting layer was dried for 10 minutes on a hot plate at 100°C to form the light-emitting layer.

Next, with the substrate in a vacuum (degree of vacuum of 1×10⁻⁴ or lower), the substrate was heated for 60 minutes at a substrate temperature of about 100°C. Then, without exposing the substrate to air, a cathode was formed by vapor deposition. Specifically, first, Ba metal was heated by a resistance heating method, and a Ba layer having a thickness of 5 nm was formed at a vapor deposition rate of 0.1 nm/sec. Then, an Al layer having a thickness of 150 nm was formed at a vapor deposition rate of 0.2 nm/sec using an electron beam vapor deposition method. Next, after producing a cathode, without exposing the substrate to air, the substrate was moved from the vapor deposition chamber to a glove box under an inert atmosphere. While maintaining the vacuum state, a sealing glass having a UV cured resin coated around its periphery was bonded on the substrate. The substrate was returned to an atmospheric pressure, and then fixed by UV irradiation to produce a polymer organic EL device.

### (Example 2)

An organic EL device was produced in the same manner as in Example 1, except that after the UV-ray/ozone treatment (second liquid-philization step) carried out following liquid-repellent layer formation in Example 1, a plasma treatment was carried out. The plasma treatment was performed using CF₄ gas for the reactive gas, with a vacuum etching apparatus (reactive ion etching apparatus, model RIE-200 NL, manufactured by SAMCO, Inc.) for 120 seconds at a CF₄ flow rate of 10 sccm, a gas pressure of 40 Pa, and a power of 40 W (hereinafter, referred to as CF₄ plasma treatment).

### (Example 3)

An organic EL device was produced in the same manner as in Example 1, except that the second liquid-philization step following liquid-repellent layer formation was carried out by an oxygen plasma treatment, and that a CF₄ plasma treatment was carried out. The oxygen plasma treatment was performed using oxygen gas for the reactive gas. The oxygen plasma treatment was performed using a vacuum etching apparatus (reactive ion etching apparatus, model RIE-200 NL, manufactured by SAMCO, Inc.) for 120 seconds at a O₂ flow rate of 40 sccm, a gas pressure of 10 Pa, and a power of 40 W. The CF₄ plasma treatment was carried out under the same conditions as in Example 2.

### (Example 4)

An organic EL device was produced in the same manner as in Example 1, except that the first liquid-philization step was carried out by an oxygen plasma treatment, and that a CF₄ plasma treatment was carried out following the second liquid-philization step. The oxygen plasma treatment and the CF₄ plasma treatment were carried out under the same conditions as in Example 3.

### (Example 5)

An organic EL device was produced in the same manner as in Example 1, except that the first and second liquid-philization steps were carried out by an oxygen plasma treatment, and that a CF₄ plasma treatment was carried out following the second liquid-philization step. The oxygen plasma treatment and the CF₄ plasma treatment were carried out under the same conditions as in Example 3.

### (Evaluation 1)

The contact angle between the liquid-repellent layer formed on the first member (ITO thin film) and the anisole (surface tension 35 dyn/cm), and the contact angle between the liquid-repellent layer formed on the second member (PI) and the anisole, were measured after the second liquid-philization step for Example 1 and after the CF₄ plasma treatment for Examples 2 to 5. An automatic contact angle measurement apparatus (OCA 20, manufactured by EKO Instruments Co., Ltd.) was used for the contact angle measurement.

### (Evaluation 2)

For Examples 1 to 5, the light-emitting layer was observed using an optical microscope after the solution for a light-emitting layer was coated and then dried for 10 minutes on a hot plate at 100°C, whereby it was confirmed that the light-emitting layer was formed throughout the inside of the rectangular opening, and that the light-emitting layer was not formed out of the rectangular opening.

### (Evaluation 3)

The ITO thin film and the cathode of each organic EL device produced in Examples 1 to 5 were respectively connected to the positive and the negative electrodes of a source meter. Then, a direct electric current was injected from the source meter. The state of the light-emitting portions was observed, whereby it was confirmed that a good light-emitting state was obtained.

Table 1 shows the evaluation results of Evaluations 1 to 3 carried out for Examples 1 to 5.

**[Table 1]**

| | First liquid-philization step (before liquid-repellent layer formation) | Second liquid-philization step (after liquid-repellent layer formation) | Plasma treatment after second liquid-philizatoin step | Evaluation 1 contact angle (°) | Evaluation 2 coating evaluation | Evaluation 3 light-emitting state |
|---|---|---|---|---|---|---|
| Example 1 | UV-ray/ozone | UV-ray/ozone | None | ITO 5 | ○ | ○ |
| | | | | PI 31 | | |
| Example 2 | UV-ray/ozone | UV-ray/ozone | CF₄ plasma | ITO 6 | ○ | ○ |
| | | | | PI 59 | | |
| Example 3 | UV-ray/ozone | Oxygen plasma | CF₄ plasma | ITO 8 | ○ | ○ |
| | | | | PI 55 | | |
| Example 4 | Oxygen plasma | UV-ray/ozone | CF₄ plasma | ITO 7 | ○ | ○ |
| | | | | PI 57 | | |
| Example 5 | Oxygen plasma | Oxygen plasma | CF₄ plasma | ITO 12 | ○ | ○ |
| | | | | PI 62 | | |

As shown in Table 1, by carrying out the liquid-philic/liquid-repellent pattern forming method according to the present invention, a significant difference can be achieved between the contact angle of the liquid-repellent layer on the ITO and the contact angle of the liquid-repellent layer on the PI. Further, by using such a substrate, a light-emitting layer having a uniform thickness can be formed. Moreover, an organic EL device having a good light-emitting state can be produced.

### INDUSTRIAL APPLICABILITY

The present invention can be utilized for forming a liquid-philic/liquid-repellent pattern on a substrate in the manufacture of an organic EL device.

## Claims

1. A liquid-philic/liquid-repellent pattern forming method comprising:
a first liquid-philization step of liquid-philizing surfaces of a first member and a second member which is provided on the first member and in which a through hole leading to the surface of the first member is provided;
a liquid-repellent layer forming step of forming a liquid-repellent layer on the surfaces of the first and second members; and
a second liquid-philization step of liquid-philizing the liquid-repellent layer to form a liquid-philic/liquid-repellent pattern,
wherein the first member and the second member are formed of different materials, and
the liquid-repellent layer comprises a material which is liquid-philized in the second liquid-philization step in a portion formed on the first member more than in a portion formed on the surface of the second member.

2. The method according to claim 1, wherein at least a surface portion of the first member is formed of an inorganic material, and at least a surface portion of the second member is formed of an organic material.

3. The method according to claim 1 or 2, wherein the liquid-repellent layer formed in the liquid-repellent layer forming step comprises a silane coupling material having a fluoroalkyl group.

4. The method according to any one of claims 1 to 3, wherein in the liquid-repellent layer forming step, the liquid-repellent layer is formed by an applying method using a liquid comprising a material to constitute the liquid-repellent layer.

5. The method according to any one of claims 1 to 4, wherein in the first and second liquid-philization steps, liquid-philization is carried out by a UV-ray ozone treatment.

6. The method according to any one of claims 1 to 5, wherein a plasma treatment is carried out after the second liquid-philization step.

7. The method according to any one of claims 1 to 4, wherein liquid-philization is carried out by an oxygen plasma treatment in at least one of the first and second liquid-philization steps, and
a plasma treatment is carried out after the second liquid-philization step.

8. The method according to claim 6 or 7, wherein the plasma treatment is carried out in an atmosphere comprising a fluorine-containing gas.

9. A method for manufacturing an organic electroluminescent device comprising at least a first electrode, a second electrode, and a light-emitting layer positioned between the first and second electrodes, the method comprising:
preparing a substrate provided with a first member which functions as the first electrode and a second member which is provided on the first member and in which a through hole leading to a surface of the first member is provided;
forming a liquid-philic/liquid-repellent pattern by performing the liquid-philic/liquid-repellent pattern forming method according to any one of claims 1 to 8;
forming a light-emitting layer by applying a liquid comprising a material which is to form the light-emitting layer to the inside of the through hole; and
forming the second electrode.
